Europäisches Patentamt

European Patent Office

Office européen des brevets

(19)

(11) Veröffentlichungsnummer : **0 021 087**
**B1**

(12) # EUROPÄISCHE PATENTSCHRIFT

(45) Veröffentlichungstag der Patentschrift :
05.10.83

(21) Anmeldenummer : 80102974.5

(22) Anmeldetag : 28.05.80

(51) Int. Cl.³ : **C 30 B   1/08**

(54) **Verfahren zur Herstellung grobkristalliner oder einkristalliner Metall- oder Legierungsschichten sowie Anwendung des Verfahrens zur Herstellung von Halbleiterschaltungen und Kontaktelektroden.**

(30) Priorität : 20.06.79 DE 2924920

(43) Veröffentlichungstag der Anmeldung :
07.01.81 Patentblatt 81/01

(45) Bekanntmachung des Hinweises auf die Patenterteilung : 05.10.83 Patentblatt 83/40

(84) Benannte Vertragsstaaten :
FR GB

(56) Entgegenhaltungen :
DE A 1 933 690
DE A 2 449 542
US A 4 046 618
US A 4 059 461
IBM TECHNICAL DISCLOSURE BULLETIN, Band 19, Nr. 11, 1977, New York, US, P.S. HO et al. : « Multibeam method for growing large-grain semiconductor films », Seiten 4438-4440

(73) Patentinhaber : **SIEMENS AKTIENGESELLSCHAFT**
**Berlin und München Wittelsbacherplatz 2**
**D-8000 München 2 (DE)**

(72) Erfinder : **Menzel, Günther, Dr.**
**Implerstrasse 38**
**D-8000 München 70 (DE)**

EP 0 021 087 B1

Verfahren zur Herstellung grobkristalliner oder einkristalliner Metall- oder Legierungsschichten sowie Anwendung des Verfahrens zur Herstellung von Halbleiterschaltungen und Kontaktelektroden

Die Erfindung betrifft ein Verfahren zur Herstellung grobkristalliner oder einkristalliner Metall- oder Legierungsschichten auf Substraten aus Keramik, Glas oder Silizium durch Umwandlung einer amorphen Schicht in den grobkristallinen oder einkristallinen Zustand mittels eines gebündelten Wärme- oder Lichtstrahls sowie Anwendung des Verfahrens zur Herstellung von Halbleiterschaltungen und Kontaktelektroden.

Aus der US-A-4 059 461 ist die Anwendung von fokussierten Laserstrahlen zur Umwandlung einer amorphen Siliziumschicht in den kristallinen Zustand bei der Herstellung von Solarzellen bekannt. Ein weiterer Hinweis für die Anwendung von Energiestrahlschreibern bei der Herstellung von Solarzellen mit grobkristallinen Schichten durch Umwandlung aus dem amorphen Zustand ist aus dem IBM Technical Disclosure Bulletin, Bd. 19, Nr. 11, 1977, auf den Seiten 4438-4440 zu entnehmen. Dabei wird das Substrat in der Anfangsphase gleichmäßig auf 500 °C erwärmt.

Dünne Metall- oder Legierungsschichten auf Substraten aus Keramik, Glas oder Silizium werden in der Elektrotechnik beispielsweise als Leiterbahnstrukturen, elektrische Widerstände oder Kondensatoren verwendet. Diese in der Dünnschichttechnik eingesetzten Metallschichten sind häufig großen thermischen Belastungen (Dauerbelastung : ca. 150 °C ; Kurzzeitbelastung : ca. 400 °C) ausgesetzt. Trotzdem muß die Langzeitstabilität der Schichteigenschaften, insbesondere auch der elektrischen Eigenschaften gewährleistet sein.

Die Metallschichten liegen nach ihrer Herstellung durch z. B. « Aufstäuben » (Sputtern) oder Aufdampfen auf Glas, Keramik oder Silizium meist in feinkristalliner Form vor. Bei höheren Temperaturen kann ein unkontrolliertes Wachsen der Kristallite einsetzen, was in vielen Fällen zu einer wesentlichen Veränderung der Schichteigenschaften führen kann.

Aufgabe der vorliegenden Erfindung ist es daher, die abgeschiedenen Schichten vor ihrer Verwendung, z. B. in integrierten Halbleiterschaltungen so zu stabilisieren, daß sie bei höheren Temperaturen oder langem Einsatz keine Eigenschaftsänderungen zeigen.

Es ist bekannt, die Schichtstabilisierung bei höherer Temperatur (T > 400 °C) durch eine Wärmebehandlung zu bewirken. Diese Temperung kann jedoch sehr ungünstig sein, da die auf dem Substrat bereits vorhandenen elektrischen Bauelemente durch die erhöhte Temperatur stark verändert werden können, weil z. B. im Falle von metallischen Leiterbahnen beim einsetzenden unkontrollierten Kristallwachstum Korngrenzen quer zur Leiterbahn entstehen können. Solche Korngrenzen erhöhen die Ausfallquote der Leiterbahnen, da an ihnen, wie der Zeitschrift « Thin Solid Films » 16 (1973) auf den Seiten 227 bis 236 zu entnehmen ist, bevorzugt Stofftransport durch Elektromigration auftritt.

Aus der deutschen Offenlegungsschrift 27 27 659 ist ein Verfahren zum Herstellen einkristalliner dünner Metallschichten bekannt, bei dem stabile Schichteigenschaften dadurch erzielt werden, daß die vorzugsweise aus Tantal bestehenden Metallschichten bei tiefer Substrattemperatur in amorpher bzw. stark gestörter Form, z. B. bei − 160 °C auf dem Substrat niedergeschlagen werden und anschließend durch vergleichsweise geringen Erwärmung des Substrats zur Kristallisation gebracht werden. Auf diese Weise werden kohärente Gitterbereiche von < 4 nm bei Erwärmen des Substrates bis auf ca. − 90 °C auf Kristalle mit einem Korndurchmesser von mindestens 70 μm vergrößert. Diese Schichten behalten auch bei sehr viel höheren Temperaturen (höher als 400 °C) ihre Eigenschaften bei, obwohl sie beim Herstellvorgang keiner höheren Temperatur als − 90 °C ausgesetzt waren.

Das der Erfindung zugrundeliegende Verfahren löst die Überführung der amorphen bzw. gestörten Schicht in den grob- oder einkristallinen Zustand nicht durch eine über das gesamte Substrat erfolgende Wärmeleitung, wie es in der deutschen Offenlegungsschrift 27 27 659 beschrieben ist, sondern auf eine andere Art, welche es gestattet, mit relativ wenig Energie den Kristallisationsvorgang gezielt auf definierte Bereiche des Substrats zu beschränken und so die auf bzw. in dem Substrat enthaltenen elektrischen Bauelemente vor zu großen thermischen Belastungen zu schützen.

Die Lösung der erfindungsgemäßen Aufgabe besteht darin, daß das Substrat während der Bestrahlung weiter auf Abscheidetemperatur gehalten wird, so daß auf dem mit der amorphen Schicht versehenen Substrat lokal und gezielt Kristallisationskeine erzeugt werden, die als Ausgangspunkt für eine einkristalline Kristallisationsfront auf der Substratoberfläche wirken und daß durch eine steuerbare Strahlführung bewirkt wird, daß sich diese Kristallisationsfront gleichmäßig in die gewünschte Richtung erstreckt.

Es liegt im Rahmen der Erfindung, eine Laserstrahlquelle, die bezüglich ihrer Einstrahlrichtung und/oder ihrer Entfernung vom Substrat variabel ausgebildet ist zu verwenden und gegebenenfalls die Strahlführung durch einen Computer zu steuern.

Durch die mit dem gebündelten Wärme- oder Lichtstrahl lokal und gezielt auf dem weiter auf der Abscheidetemperatur, — die in einem Bereich von Zimmertemperatur bis ca. − 160 °C liegen kann, — gehaltenen Substrat erzeugten Kristallisationskeime wird die Anzahl der bei bekannten Verfahren insgesamt entstehenden Kristallisationskeime drastisch reduziert, was sich im weiteren in einer verringerten Kornzahl und damit in einer gesteigerten Kristallitgröße mit stabileren Schichteigenschaften äußert. Da das beschichtete Substrat bei der Umwandlung weiter auf tiefer Temperatur gehalten wird, entstehen keine zusätzlichen Keime durch Inhomogenitäten der Substratoberfläche, welche durch Verunreinigungen oder Energiespitzen verursacht werden könnten.

In einer Weiterbildung des Erfindungsgedankens ist vorgesehen, zur Herstellung definiert geformter Flächen bzw. Linien auf der Metallschicht den auf die amorphe Schicht auftreffenden gebündelten Strahl durch eine Vorrichtung nach dem Prinzip eines Fotoapparateverschlusses mit einstellbarer Geschwindigkeit bezüglich seiner Fokussierung zu verändern. Dadurch wird eine steuerbare Strahlführung — welche auch computergesteuert sein kann — erzielt, mit deren Hilfe die Kristallisationsfront gleichmäßig in gewünschte Richtungen geführt wird. Auf die Weise wird auch die zufällige Entstehung von Kristallisationskeimen verhindert, so daß sich sehr große, in ihrer Form beeinflußbare bzw. einkristalline Schichten bilden.

Der durch die Bestrahlung ausgelöste Kristallisationsvorgang in einer amorphen bzw. gestörten Schicht erfordert relativ wenig Energie und erfolgt sehr rasch ; das hat den Vorteil, daß nicht das gesamte beschichtete Substrat in umständlicher und zeitraubender Weise erwärmt werden muß. Außerdem kann der Kristallisationsvorgang auf definierte Bereiche beschränkt bleiben, wodurch die auf dem Substrat bereits vorhandenen elektrischen Bauelementstrukturen in keiner Weise geschädigt werden.

Durch das Verfahren nach der Lehre der Erfindung ist die Möglichkeit gegeben, strukturierte Bahnen, z. B. Leiterbahnen oder auch ausgewählte Siliziumbereiche, wie sie beispielsweise für Kontaktelektroden bei Solarzellen erforderlich sind, in einkristalliner Form herzustellen. Dabei wird die Schicht bei relativ tiefer Temperatur in amorpher oder stark gestörter Form entweder strukturiert auf dem Substrat abgeschieden oder auch nach ganzflächiger Abscheidung mittels einer Fotoätztechnik strukturiert und anschließend durch geschwindigkeitsgesteuertes und möglicherweise mehrfaches Abfahren der Struktur mittels des gebündelten Lichtstrahles z. B. mittels eines computergesteuerten Laserstrahls, in die einkristalline Form übergeführt. Während der Umwandlung wird das Substrat weiter auf der Abscheidetemperatur gehalten, um die Entstehung zusätzlicher Kristallisationskeime zu verhindern.

Eine geeignete Formgebung der Struktur, z. B. ein Mäander, kann zusätzlich die Keimauswahl beeinflussen bzw. erleichtern und damit die sogenannte « Dünnhalsmethode » ersetzen.

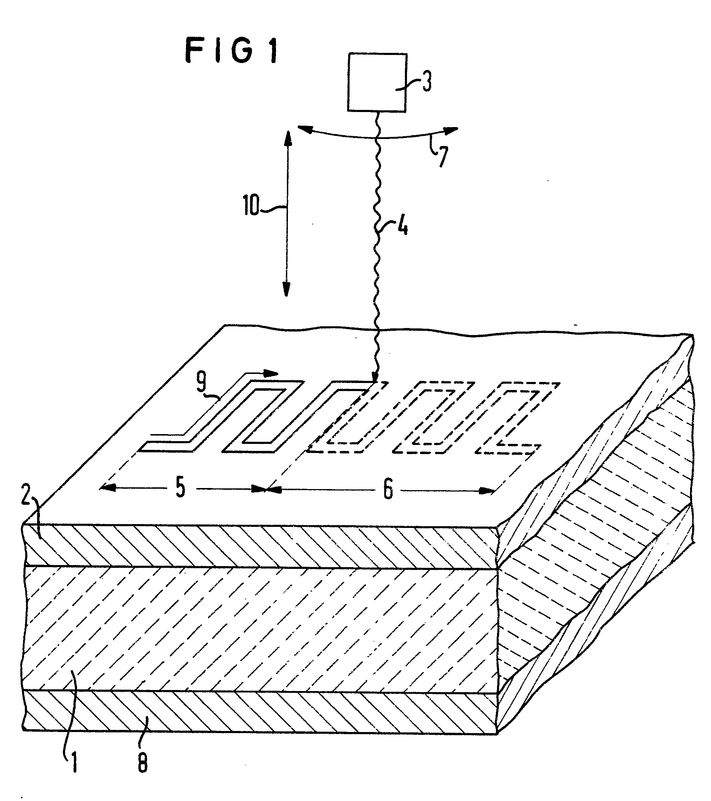

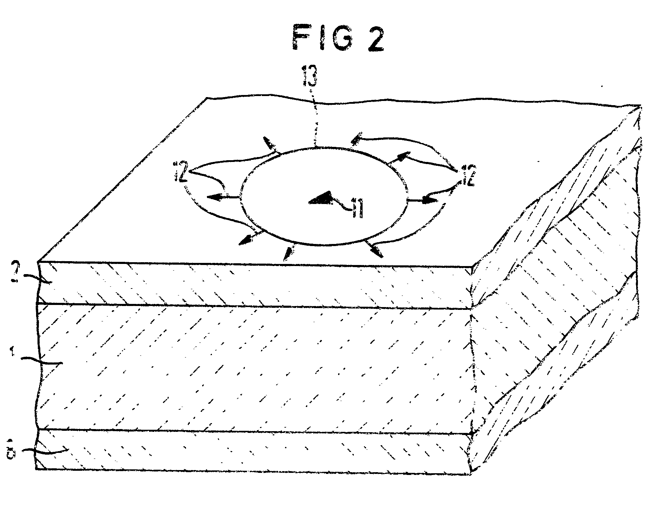

Im folgenden wird die Erfindung anhand zweier Ausführungsbeispiele und der Figuren 1 und 2 noch näher erläutert. Dabei zeigt Figur 1 eine Anordnung unter Verwendung eines gesteuerten Laserstrahls und Figur 2 die Ausbildung der Kristallisationsfront unter Verwendung des Prinzips eines Fotoapparatverschlusses. In Figur 1 ist im Schnitt und in der Draufsicht eine Anordnung, bestehend aus einem Keramiksubstrat 1 und einer durch ein Sputterverfahren bei

— 160 °C aufgebrachten amorphen Tantalschicht 2 gezeigt, welche mit einem — in einer auch weiter entfernbaren (siehe Pfeil 10) — Laserlichtquelle 3 erzeugten und gebündelten Laserstrahl 4 in Pfeilrichtung 9 überstrichen wird. Dabei ist der Bereich 5 der aufgesputterten Schicht 2 bereits in die einkristalline Form übergegangen, während der Bereich 6 (gestrichelt dargestellt) noch mit dem Laserstrahl überfahren werden soll. Die restlichen Bereiche der Schicht 2 bleiben als amorphe bzw. gestörte Schicht bestehen. Der Doppelpfeil 7 soll die variable Einstrahlrichtung andeuten. Durch ein Kühlsystem 8 wird das beschichtete Keramiksubstrat (1, 2) während der Bestrahlung auf konstanter Kühltemperatur (— 160 °C) gehalten.

In Figur 2 gelten für gleiche Teile die gleichen Bezugszeichen wie in Figur 1. Der Übersichtlichkeit wegen ist die Laserquelle mit dem mechanischen Verschluß in der Figur nicht dargestellt. Der auf der beschichteten Substratoberfläche (1, 2) durch das Öffnen des Verschlusses spontan entstehende Kristallisationskeim 11 vergrößert sich in Richtung der Pfeile 12 und bildet in der in der Figur 2 dargestellten Weise die einkristalline Fläche 13. Dabei kann der Verschluß in einer Weise geöffnet werden, daß jede beliebige Fläche entstehen kann.

### Ansprüche

1. Verfahren zur Herstellung grobkristalliner oder einkristalliner Metall- oder Legierungsschichten auf Substraten aus Keramik, Glas oder Silizium durch Umwandlung einer amorphen Schicht in den grobkristallinen oder einkristallinen Zustand mittels eines gebündelten Wärme- oder Lichtstrahls, dadurch gekennzeichnet, daß das Substrat während der Bestrahlung weiter auf Abscheidetemperatur gehalten wird, so daß auf dem mit der amorphen Schicht versehenen Substrat lokal und gezielt Kristallisationskeime erzeugt werden, die als Ausgangspunkt für eine einkristalline Kristallisationsfront auf der Substratoberfläche wirken, und daß durch eine steuerbare Strahlführung bewirkt wird, daß sich diese Kristallisationsfront gleichmäßig in die gewünschte Richtung erstreckt.

2. Verfahren nach Anspruch 1, dadurch gekennzeichnet, daß eine Laserstrahlquelle verwendet wird, die bezüglich ihrer Einstrahlrichtung und/oder ihrer Entfernung vom Substrat variabel ausgebildet ist.

3. Verfahren nach den Ansprüchen 1 und/oder 2, dadurch gekennzeichnet, daß die Strahlführung durch einen Computer gesteuert wird.

4. Verfahren nach den Ansprüchen 1 bis 3, dadurch gekennzeichnet, daß zur Herstellung definiert geformter einkristalliner Flächen bzw. Linien auf der Metall- oder Legierungsschicht der auf die amorphe Schicht auftreffende, gebündelte Strahl durch eine Vorrichtung nach dem Prinzip eines Fotoapparateverschlusses mit einstellbarer Geschwindigkeit bezüglich seiner Fokussierung verändert wird.

5. Verwendung des Verfahrens nach den Ansprüchen 1 bis 4 zur Herstellung von Metallisierungen für integrierte Halbleiterschaltungen.

6. Verwendung des Verfahrens nach den Ansprüchen 1 bis 4 zur Herstellung von Kontaktelektroden für Solarzellen, vorzugsweise aus amorphem Silizium.

## Claims

1. A process for the production of coarsely crystalline or mono-crystalline metal or alloy layers on substrates made of ceramic, glass or silicon by converting an amorphous layer into the coarsely crystalline or mono-crystalline state by means of a focussed heat or light beam, characterised in that, during the irradiation, the substrate is additionally maintained at the deposition temperature, so that on the substrate, which is provided with the amorphous layer, crystallization seeds are produced locally and in controlled manner, which serve as starting point for a monocrystalline crystallization front on the substrate surface ; and that a controllable guiding of the beam is effected such that the crystallization front extends evenly in the required direction.

2. A process as claimed in Claim 1, characterised in that a laser beam source is used which is formed to be variable with respect to its direction of irradiation and/or its distance from the substrate.

3. A process as claimed in Claim 1 and/or 2, characterised in that guiding of the beam is controlled by a computer.

4. A process as claimed in Claims 1 to 3, characterised in that, in order to produce definitelyformed mono-crystalline areas or lines on the metal or alloy layer, the focussed beam impinging on the amorphous layer is changed as regards its focussing by a device operating on the principle of a camera shutter with adjustable speed.

5. The use of the process as claimed in Claims 1 to 4 for the production of metallizations for integrated semiconductor circuits.

6. The use of the process as claimed in Claims 1 to 4 for the production of contact electrodes for solar cells, preferably made of amorphous silicon.

## Revendications

1. Procédé de préparation de couches macrocristallines ou monocristallines de métaux ou d'alliages sur des substrats en céramique, en verre ou en silicium, en faisant passer une couche amorphe à l'état macrocristallin ou monocristallin au moyen d'un faisceau calorifique ou lumineux concentré, caractérisé en ce qu'il consiste à continuer à maintenir le substrat à la température de dépôt pendant l'irradiation de manière à produire, localement et d'une façon adéquate sur le substrat muni de la couche amorphe, des germes de cristallisation qui agissent comme point de départ d'un front de cristallisation monocristallin sur la surface du substrat, et à faire en sorte, par un guidage du faisceau qui peut être commandé, que ce front de cristallisation s'étende uniformément dans la direction souhaitée.

2. Procédé suivant la revendication 1, caractérisé en ce qu'il consiste à utiliser une source de faisceau laser, qui est agencée de manière variable pour ce qui concerne sa direction d'incidence et/ou son éloignement par rapport au substrat.

3. Procédé suivant les revendications 1 et/ou 2, caractérisé en ce qu'il consiste à commander le guidage du faisceau par un ordinateur.

4. Procédé suivant les revendications 1 à 3, caractérisé en ce qu'il consiste, pour la réalisation de surfaces et de lignes monocristallines, formées de manière définie sur la couche de métal ou d'alliage, à modifier, du point de vue de sa focalisation, le faisceau concentré arrivant sur la couche amorphe par un dispositif agissant suivant le principe d'un obturateur d'appareil photographique à vitesse réglable.

5. Utilisation du procédé suivant les revendications 1 à 4 pour la préparation de métallisation pour des circuits intégrés à semiconducteurs.

6. Utilisation du procédé suivant les revendications 1 à 4 pour la fabrication d'électrodes de contact pour piles solaires, de préférence en silicium amorphe.

# F I G 1

# FIG 2